# DEMANDE DE BREVET EUROPEEN

(11) **EP 0 944 115 A1**
(43) Date de publication de la demande: **22.09.1999**
(21) Numéro de dépôt: 99400486.9
(22) Date de dépôt: 01.03.1999
(51) Int. Cl.: H01L 23/66

(54) **Amplificateur à grand gain**

(30) Priorité: 19.03.1998 FR 9803355
(71) Demandeur: ALCATEL, 75008 Paris (FR)
(72) Inventeur: Rattay, Bernard, 95540 Mery S/Oise (FR); Rampazzo, Philippe, 91610 Ballancourt Sur Essonne (FR); Guillard, Jean-Christophe, 78630 Morainvilliers (FR); Soulard, Michel, 95370 Montigny Les Cormeilles (FR)
(74) Mandataire: Smith, Bradford Lee

(57) **Abrégé**

Pour réaliser un amplificateur à grand gain dans une bande hyperfréquence, on propose de relier ensemble, des circuits d'amplification et de recouvrir le boîtier qui les contient, d'un couvercle (31). On ménage dans l'espace (33) situé entre le couvercle et les circuits d'amplification, à l'intérieur du boîtier, des guides d'onde (41-43) dont la fréquence de coupure est telle qu'elle ne laisse se propager aucun des modes pouvant régner aux fréquences de la bande utile. On montre qu'en formant ces guides d'onde dans cet espace, au lieu de le remplir d'absorbants, on obtient une bien meilleure isolation radioélectrique entre la sortie et l'entrée pour éviter des réinjections parasites. De ce fait on peut, dans un même boîtier, réaliser une amplification pouvant aller jusqu'à 90 dB alors qu'auparavant la limite à 45 dB par boîtier était infranchissable.

## Description

La présente invention a pour objet, un amplificateur à grand gain utilisable dans le domaine des hyperfréquences. Elle peut être utilisée notamment dans le domaine du radar, dans celui des faisceaux hertziens, dans les transmissions par satellites, et dans les systèmes de distribution multipoints de télévision (LMDS). Les gammes de fréquence concemées par l'invention sont plus particulièrement des gammes de fréquence allant de 1 GHz à 100 GHz. Des utilisations peuvent néanmoins être considérées en dehors de ces domaines et en dehors de cette plage. L'invention trouve sa place dès qu'une propagation radioélectrique est envisagée.

L'invention a pour objet de proposer un amplificateur à grand gain et à faible coût. Par grand gain, on entend des amplifications supérieures à 40 dB et pouvant aller jusqu'à 100 dB.

Les circuits utilisés pour réaliser ces fonctions d'amplification, comportent des composants à base de circuits dits MMIC, monolithic microwave integrated circuit. Ces composants MMIC comportent des circuits intégrés reliés entre eux par des lignes de transmission. L'architecture, les longueurs et les dispositions des lignes de transmission à l'intérieur de ces composants MMIC sont de nature à constituer un circuit d'amplification hyperfréquence intrinsèquement non oscillant. En pratique, des ensembles d'amplification hyperfréquence comportent une plaquette isolante (par exemple en céramique, en verre-polytétrafluoroéthylène, en résine époxy) dans laquelle sont usinées des alvéoles pour recevoir les composants MMIC. Cette plaquette isolante porte les pistes conductrices pour relier les composants entre eux. Les composants MMIC possèdent une entrée, par où est injecté un signal à amplifier, et une sortie d'où sort le signal amplifié. Un composant MMIC a une forme souvent parallélépipédique, l'entrée étant située d'un côté du composant MMIC, la sortie étant située sur un côté opposé au côté d'entrée.

Le signal amplifié rayonne naturellement dans l'espace situé à proximité de la sortie du composant. Ce rayonnement se propage alors malheureusement jusqu'à l'entrée. Il en résulte un phénomène de réinjection à l'entrée des signaux produits à la sortie. Ce phénomène est un phénomène de radio-émission.

Pour limiter les effets perturbateurs de ces phénomènes, il est prévu de munir les composants MMIC d'un capot métallique et de matériaux absorbants environnants. Ainsi, des matériaux absorbants sont placés d'une part entre les circuits intégrés du composant MMIC et le capot. D'autre part, le composant MMIC muni de son capot est lui-même placé dans un boîtier possédant une entrée en regard de l'entrée du composant MMIC et une sortie en regard de la sortie du composant MMIC. L'espace entre un couvercle de ce boîtier et le capot, est également rempli de matériaux absorbants de manière à éviter la propagation récursive des ondes amplifiées. Le boîtier est relié quant à lui à d'autres circuits par des câbles de liaison blindés.

L'inconvénient présenté par les absorbants est qu'ils remplissent imparfaitement leur rôle. De ce fait, malgré le soin apporté au choix des absorbants et à leur disposition, les limites d'amplification atteignables avec un tel circuit d'amplification, dans son boîtier, sont de l'ordre de 40 dB. Au-delà, pour certaines composantes spectrales de la bande de fréquence, le composant MMIC entre en oscillation (le gain est très important). Ou alors cette réinjection provoque une atténuation importante. En définitive, dans la bande utile, le gain effectivement réalisé évolue d'une manière anarchique, bien au-delà ou bien en deçà de la valeur d'amplification qui lui avait été assignée. De tels amplificateurs ne sont alors pas utilisables, ils produisent trop de distorsions du signal amplifié.

Pour remédier à ce problème, pour par exemple réaliser une amplification de 90 dB, il est prévu de mettre en cascade plusieurs boîtiers, par exemple trois boîtiers, comportant des circuits d'amplification. Ceci évidemment, multiplie le prix sensiblement par trois.

En outre, les matériaux absorbants présentent l'inconvénient de dégazer. Par sublimation, ils diffusent des particules qui vont, en particulier, s'introduire dans les canaux de conduction des transistors à l'arséniure de gallium, AsGa, utilisés dans les circuits intégrés. Ce dégazage conduit à une détérioration de ces transistors. Par ailleurs, entre le capot et le couvercle, le pouvoir d'amortissement des matériaux absorbants est pratiquement limité à 50 dB, dans le meilleur des cas.

L'invention a pour objet de remédier à ce problème en proposant une solution qui permette de concevoir des amplificateurs à grand gain, par exemple couramment de 60 dB voire de 80 ou 90 dB, sans avoir à souffrir du phénomène de réinjection parasite. Dans ces conditions, il sera possible de constituer dans un même boîtier un amplificateur à grand gain : le coût de l'ensemble peut être globalement considéré comme divisé par trois.

Le principe de l'invention consiste à ménager dans les espaces qui sont situés, à l'endroit du capot du circuit MMIC, au-dessus et en dessous de ce capot, des guides d'onde, appelés auxiliaires et complémentaires respectivement. La fréquence de coupure de ces guides d'onde auxiliaires et complémentaires est choisie pour être supérieure à la limite haute de la bande passante utile à amplifier. De ce fait, tous les signaux produits dans la bande utile auront une fréquence inférieure à la fréquence de coupure des guides d'onde constitués : ils ne pourront pas s'y propager. De ce fait, la réaction de la sortie du circuit d'amplification sur son entrée va être à ce point réduite qu'elle ne viendra pas les perturber. Il est alors possible de concevoir des circuits d'amplification à très grands gains. En pratique, l'invention a été testée avec des gains allant entre 80 et 90 dB.

L'avantage de l'invention est bien entendu, de permettre la constitution de guides d'onde remplis de matériaux n'ayant plus nécessairement de très bonnes caractéristiques d'absorption mais ayant par ailleurs l'avantage de ne pas dégazer et donc de ne pas polluer les transistors des composants MMIC.

L'invention a donc pour objet un amplificateur à grand gain pour amplifier des signaux électriques distribués dans une bande haute fréquence, comportant un circuit d'amplification, ce circuit d'amplification étant monté sur un support, par exemple une semelle métallique à l'intérieur d'un composant MMIC, et étant recouvert d'un capot, et ce circuit d'amplification possédant, d'un premier coté une entrée de signal et, d'un deuxième coté opposé à ce premier coté, une sortie de signal, caractérisé en ce qu'il comporte des moyens de morceler en guides d'onde auxiliaires l'espace situé entre le capot et le support, les caractéristiques des guides d'onde ainsi réalisés étant insuffisantes pour propager entre la sortie et l'entrée un signal dont la fréquence est située dans la bande haute fréquence de l'amplificateur. De préférence, l'espace situé au dessus du capot est morcelé de la même manière, avec des guides d'ondes complémentaires présentant les mêmes caractéristiques que les guides d'onde auxiliaires.

L'invention sera mieux comprise à la lecture de la description qui suit et à l'examen des figures qui l'accompagnent. Celles-ci ne sont données qu'à titre indicatif et nullement limitatif de l'invention. Les figures montrent :
Figures 1 et 2 : une représentation respectivement en coupe et vue de dessus d'un composant MMIC réalisant un amplificateur à grand gain selon l'invention ;
Figure 3 : une représentation schématique des gains en amplification obtenus par l'amplificateur de l'invention et par des amplificateurs de l'état de la technique ;
Figures 4 et 5 : des vues en perspective d'un boîtier avec son couvercle, muni d'un composant MMIC d'amplification selon l'invention ;
Figure 6 : une variante de la figure 5.

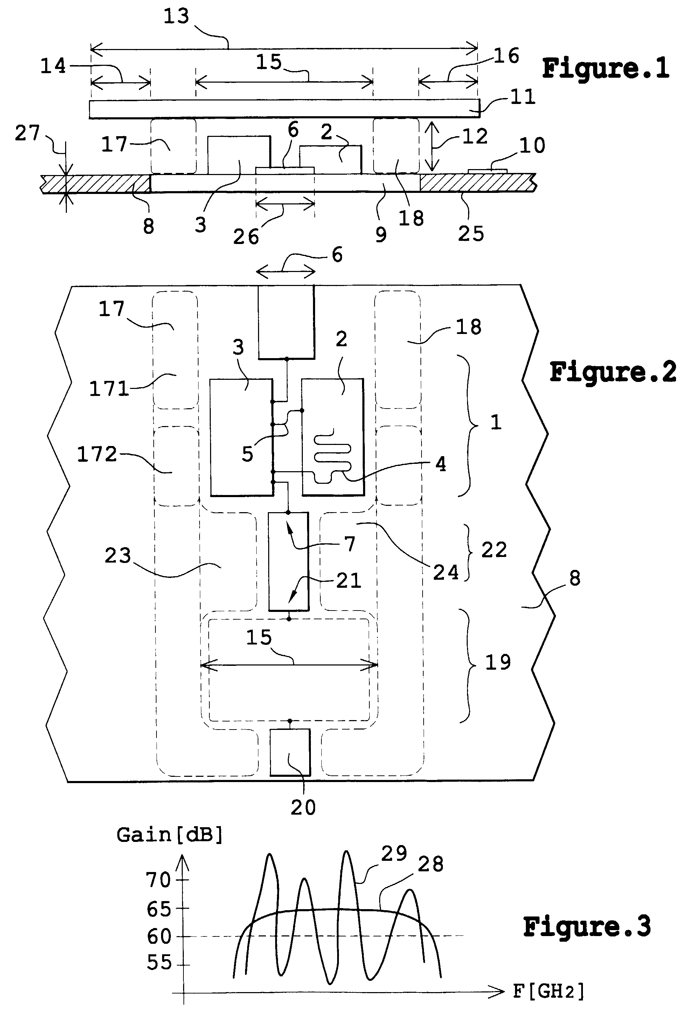

Les figures 1 et 2 montrent un amplificateur à grand gain selon l'invention. Sur la figure 2, l'amplificateur comporte au moins un circuit 1 d'amplification. Ce circuit comporte des composants électroniques 2 et 3 en circuit intégré. Ces composants 2 et 3 sont reliés entre eux par des connexions 4 et 5 dont la géométrie et la répartition sont particulièrement adaptées au caractère hyperfréquence du circuit d'amplification. Les connexions sont réalisées sous formes de fils aériens, évidemment sans contact avec une masse de ce circuit. Le circuit 1 possède, d'un premier côté une entrée 6 de signal et d'un deuxième côté, opposé au premier côté, une sortie 7 de signal. Le signal entre par l'entrée 6, est traité par les circuits intégrés 2 et 3 et sort, amplifié, à la sortie 7.

La figure 1 montre schématiquement en coupe, ces éléments. Elle montre que les circuits 2 et 3 sont implantés sur un support. Le support comporte une plaquette 8 isolante. La plaquette 8 comporte dans un évidement central une semelle métallique 9. Des métallisations 10 réalisées sur la plaquette 8 permettent de transmettre aux circuits intégrés 2 et 3 des signaux de commande, notamment l'alimentation électrique et des signaux de commande de gain, pour amplifier les signaux admis sur la connexion 6. Les signaux de commande ont en tous les cas des fréquences bien inférieures à la fréquence du signal haute fréquence à amplifier. En pratique, ces signaux sont soit continus, il s'agit alors de l'alimentation électrique du circuit intégré, soit basse fréquence, au plus haut 100 MHz.

Le circuit 1 est recouvert d'un capot métallique 11. Le capot 11 est retenu sur la semelle 9 par des piliers ou murs métalliques non représentés. Dans l'état de la technique, un espace 12 situé entre la semelle 9 et le capot 11 était bourré de matériaux absorbants avec les inconvénients qu'on a dits.

La largeur 13 du capot est suffisante pour qu'à l'intérieur de l'espace entre la plaquette 8 et le capot 11, puissent se propager des modes de propagation radioélectrique du signal amplifié et disponible à la sortie 7.

Dans l'invention, pour éviter cette propagation, on a morcelé la largeur 13 en plusieurs guides d'onde, ici 3 guides d'onde : les guides d'onde 14, 15 et 16. Comme on montrera plus loin, les caractéristiques d'épaisseur et de largeur de ces guides sont telles quelles sont insuffisantes pour propager un mode quelconque du signal amplifié disponible à la sortie 7. On sait que pour empêcher la propagation d'un mode dit TE01 dans un guide d'onde, il suffit que la largeur du guide d'onde soit inférieure à λ/4, *λ* étant la longueur d'onde, dans le diélectrique du guide d'onde, de l'onde propagée. En présence d'une plaquette comportant des lignes microbandes, le mode le plus permissif est le mode LSM11 (longitudinal magnétique) dont les dimensions caractéristiques ne sont pas λ/4 : elles sont inférieures et complexes à calculer. Néanmoins, même pour ce mode, il existe une fréquence de coupure, calculable, en deçà de laquelle sa propagation est impossible. Et si ce mode LSM11 ne se propage pas, aucun autre mode supérieur ne se propage.

L'idée de l'invention est donc, pour chacun des guides d'onde 14 à 16, d'en connaître les caractéristiques. C'est facile puisqu'on connaît la largeur 13 et qu'on connaît le nombre de morceaux et la taille des sections qu'on se détermine à réaliser. Pour les caractéristiques des guides d'onde ainsi constitués, on calcule la fréquence de coupure du mode LSM11. Ces calculs sont complexes mais de type connu. Ils sont par exemple disponibles dans l'ouvrage Handbook of Microwave Integrated Circuit de Reinmut K. HOFFMANN, publié chez ARTECH HOUSE, à NORWOOD, ETATS UNIS d'AMERIQUE. On détermine alors avec ces calculs une fréquence de coupure. On regarde ensuite si cette fréquence de coupure ainsi trouvée est supérieure à la limite haute de la bande haute fréquence pour laquelle on destine le circuit d'amplification. Si cette fréquence de coupure est supérieure à la limite haute de la bande haute fréquence, la répartition envisagée en morceaux des guides d'onde est acceptable. Si ce n'est pas le cas, il faut faire morceler encore plus l'espace 13 avec des guides d'onde à sections réduites.

Dans l'exemple représenté sur la figure 1, qui est un exemple pratique, on a ainsi réalisé deux barrettes respectivement 17 et 18 complètement métalliques. Le matériau interne des barrettes 17 et 18 présente par ailleurs l'avantage d'être stable : de ne pas dégazer. Dans un exemple c'est du métal usiné. On peut aussi utiliser une céramique avec des trous métallisés. Les barrettes 17 et 18 sont disposées au contact entre la semelle 9 et le capot 11 de façon à constituer des séparations entre guides d'onde. Un premier guide d'onde auxiliaire 14 est alors formé par un mur métallique qui borde le composant MMIC sur la gauche (figure 1), la semelle 9 en dessous, le capot 11 au dessus, et la barrette 17 à droite. Un deuxième guide d'onde auxiliaire 16 est formée symétriquement, à droite, avec le concours de la barrette 18.

Le troisième espace 15 est un guide d'onde auxiliaire à air dont les parois métalliques sont constituées par le capot 11 d'une part, et les parois des barrettes 17 et 18, d'autre part. En tout état de cause, le morcellement en trois de l'espace 13 ainsi constitué a été tout à fait suffisant pour conduire au résultat recherché.

La figure 2 montre par ailleurs, un deuxième circuit d'amplification 19 monté en cascade et dans les mêmes conditions que le circuit 1. Le circuit d'amplification global ainsi constitué comporte un capot 11 unique qui s'étend de l'entrée 6 à une sortie 20 du circuit 19. On distingue le guide d'onde central 15 formé par les barrettes 17 et 18 placées sur les bords des circuits intégrés 2 et 3.

Dans une utilisation particulière, pour des raisons particulières d'amplification entre la sortie 7 du circuit 1 et une entrée 21 du circuit 19, la fréquence des signaux a dû être doublée. En conséquence, les contraintes de fréquences de coupures sont plus fortes. Aussi, pour éviter que des signaux, à fréquence double, ne se propagent de la sortie 20 jusqu'à l'entrée 6, même par l'intermédiaire du guide d'onde 15 (de section trop grande pour une onde à fréquence double et qui la laisserait passer), on a placé dans un espace de transition 22 entre la sortie 7 du circuit 1 et l'entrée 21 du circuit 19, d'autres barrettes 23 et 24 respectivement. En définitive, dans l'espace de transition 22, on trouve les sections métalliques 17, 23, 24 et 18 ainsi qu'un espace à air libre entre les structures 23 24 et le capot 11. La réduction de la largeur de l'espace 22 permet de s'affranchir des conséquences du doublement de la fréquence. A l'endroit de l'espace 22, les caractéristiques des guides d'onde auxiliaires sont donc modifiées : le guide d'onde 15 y est lui-même réduit en largeur.

La plaquette 8 forme, à l'endroit de l'entrée 6 et de la sortie 20, avec des languettes métallisées correspondantes et une métallisation 25 sous-jacente à la plaquette 8, des guides d'onde. L'impédance caractéristique de ces derniers dépend de la largeur 26 de ces languettes et de l'épaisseur 27 de la plaquette 8. Une impédance caractéristique de ces guides d'onde, dans un exemple, est de 50 Ohms.

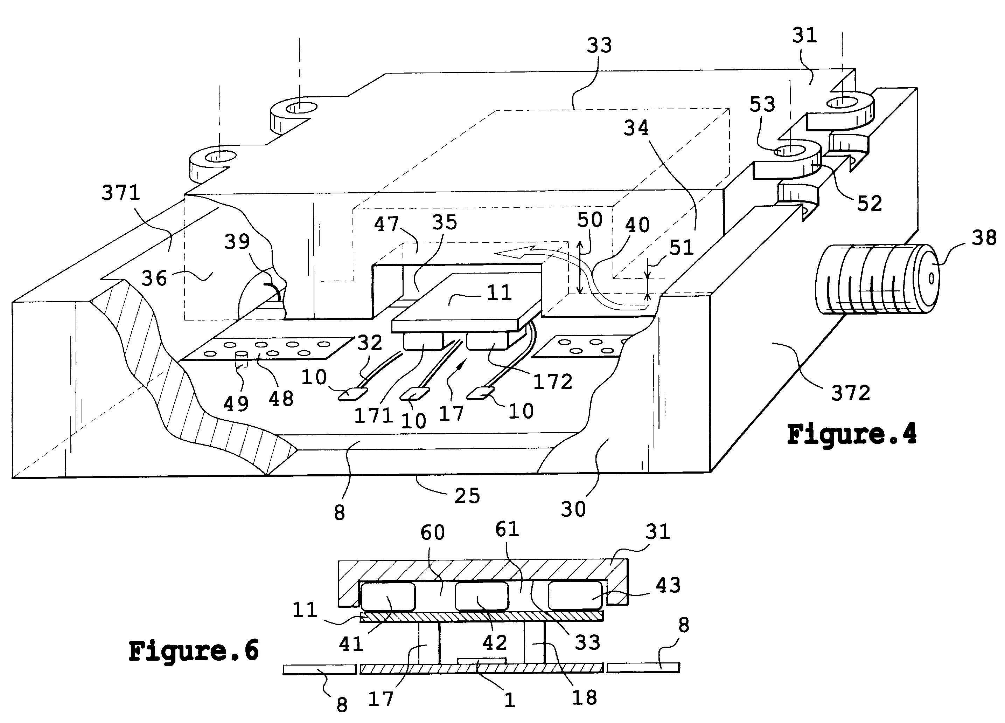

La figure 4 montre un boîtier 30 et son couvercle 31 qui contiennent un composant d'amplification MMIC comme celui décrit sur les figures 1 et 2. De ce demier, on distingue essentiellement le capot 11, une barrette latérale 17 et les plots 10 de connexion de commande à l'intérieur du composant MMIC. Ces plots 10 sont reliés au circuit d'amplification par des connexions 32. Les connexions 32 peuvent passer en extrémité des structures 17 (pour ne pas entrer en contact avec elles), ou encore passer entre deux tronçons 171 et 172 longitudinaux de la structure 17 qui est alors divisée en deux parties. Dans un exemple les deux tronçons 171 et 172 sont d'égale longueur. On distingue également la couche 25 de métallisation inférieure de la plaquette 8. Celle-ci s'étend également en dessous et au contact de la semelle 9.

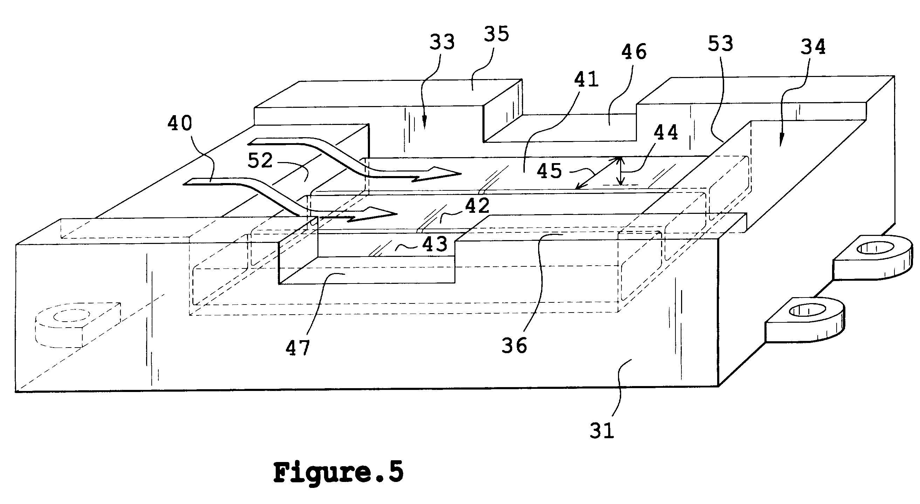

La figure 5 montre le couvercle 31 seul, en position retournée. Le couvercle 31 comporte une cavité 33 profonde qui est ménagée dans un canal 34. Ainsi, le couvercle 31 possède des parois latérales 35 et 36 situées de part et d'autre du canal 34. Dans l'exemple représenté, le couvercle est en métal, massif. Par exemple, il est taillé dans un bloc d'aluminium argenté ou de laiton, par fraisage ou il est réalisé directement en fonderie.

Comme le montre la figure 4, la cavité profonde 33 sert à recevoir, au-dessus de la plaquette 8, l'encombrement présenté par le composant MMIC 11. Le canal 34 sert à recevoir des pistes 35 qui mènent d'une face avant 371 du boîtier 30 à l'entrée 6 du composant MMIC 11, et de la sortie 7 ou 20 du composant MMIC 11 jusqu'à une face arrière 372 du boîtier 30. Les pistes 35 peuvent être réalisées dans la continuité des pistes 6, 7, 21, et 20. Quand il y a deux composants MMIC dans un même boîtier, il a deux cavités profondes. Si le composant MMIC est double, comme sur les figures 1 et 2, il n'y en a qu'une seule. Les pistes 35 sont reliées fonctionnellement notamment par un fil soudé 39 à des broches telles que 38 de type coaxial montées sur les faces 36 et 37.

A la sortie du composant MMIC, dans le canal 34, malgré l'adaptation la plus parfaite possible présentée par les pistes 35 sur la plaquette 8, l'onde amplifiée rayonne et se propage en retour vers l'entrée selon un parcours 40. Autrement dit, l'onde emprunte le canal 34, passe par la cavité profonde 33 et a tendance à vouloir se propager dans le canal jusqu'à l'entrée du composant d'amplification MMIC11.

Sur la figure 5, on montre que la propagation 40 est contrariée par la présence, au fond de la cavité profonde 33, de guides d'onde 41 à 43 qui morcellent l'espace situé dans cette cavité profonde 33 entre le couvercle 31 et le capot 11 (non représenté sur la figure 5). De préférence, les guides d'onde 41 à 43 seront réalisés par des matériaux élastiques de façon à être sûr que les faces conductrices de ces guides 41 et 43 entrent en contact, d'une part avec le fond de la cavité profonde 33, et d'autre part avec le capot 11 quand le couvercle 31 est mis en place sur le boîtier 30.

Les hauteur 44 et largeur 45 des guides 41 à 43 sont déterminées comme précédemment pour amener à une fréquence de coupure du mode TE10, ici, qui soit supérieure à la limite haute de la bande passante utile dans l'application d'amplification envisagée. L'espace au dessus du capot est ainsi morcelé en plusieurs guides d'onde complémentaires, chacun d'eux possédant des caractéristique inférieure à la coupure.

En pratique, le matériau utilisé pour les guides d'onde complémentaires est tout simplement du joint de blindage électromagnétique, utilisable pour blinder les feuillures des portes des armoires électroniques. C'est très bon marché et convient tout à fait pour l'usage indiqué. Les parois extérieures de ces tronçons de joint forment les quatre faces de chacun des guides complémentaires. L'intérieur de ces joint peut être une simple mousse isolante, ou une mousse chargée en métal, car ceci constitue essentiellement l'intérieur diélectrique des guides d'onde complémentaires.

En extrapolant, il est possible de ne placer qu'un tronçon de joint sur deux dans le sens de la largeur. Ceci réduit la quantité de joint requis et le temps de pose dans un processus industriel. Dans ce cas, certains guides d'onde complémentaires seront formés par les parois adjacentes des guides placés de part et d'autre et ces guides d'onde comporteront de l'air comme diélectrique à la place de la mousse isolante. Cette configuration est illustrée sur la figure 6. Dans celle-ci, des guides d'onde 60 et 61 comportent de l'air comme diélectrique, ce qui permet, dans cet exemple, de n'utiliser que trois joints 41 42 43 au lieu de cinq joints. On pourrait également placer deux joints aux positions 60 et 61 au lieu des joints 41 42 et 43. Les tronçons 41-43 formeraient ainsi des guides d'onde remplis d'air.

Les parois 35 et 36 possèdent par ailleurs, des créneaux 46 et 47. Le créneau 47 montré sur la figure 4, est utile pour permettre le passage des connexions 32 de commande à destination du composant MMIC 11. Par ailleurs, les parois 35 et 36 reposent, de part et d'autre des créneaux, sur des métallisations telles que 48 réalisées au-dessus de la plaquette 8. Les métallisations 48 sont de préférence reliées par des trous métallisés 49 à la couche conductrice 25 de la plaquette 8. La couche 25 est de préférence portée à la masse.

Dans un exemple, la hauteur 50 du créneau 46 est de l'ordre de 1 mm alors que la profondeur 51 du canal 34 est de l'ordre de 2 mm. De ce fait, le boîtier 30 et le couvercle 31, forment avec la plaquette 8 un ensemble parfaitement étanche à la propagation d'onde électromagnétiques produites par le composant MMIC 11. Le couvercle 31 est fixé sur le boîtier 30 par des pattes 52 munies d'un alésage 53 de vissage.

Une des caractéristiques de l'invention est donc que le capot du composant MMIC 11 est métallique au lieu d'être formé, comme dans l'état de la technique, d'un matériau céramique isolant. Les caractéristiques de conduction du capot 11 sont de nature à constituer les guides d'onde à l'intérieur et à l'extérieur du composant d'amplification MMIC.

On s'est aperçu que si les guides d'onde 41 à 43 ne sont pas aboutés contre des flancs d'entrée 52 et de sortie 53 de la cavité profonde 33, le phénomène de coupure est exactement le même. La propagation de l'onde inverse est empêchée. Tout se passe bien comme si les guides 41 à 43 constituaient des passages privilégiés, mais en impasse, pour les ondes de retour. Bien entendu, si la fréquence de l'onde à bloquer augmente, il suffit d'augmenter le nombre des guides 41 à 43, en réduisant corrélativement leur taille.

La figure 3 montre, dans un exemple pour une amplification moyenne de 60 dB, une courbe 28 d'amplification obtenue avec l'amplificateur de l'invention et une courbe 29 obtenue dans les mêmes conditions dans l'état de la technique. Si avec les signaux de commande appliqués sur les plots 10, on augmentait encore le gain, le caractère anarchique de l'amplification 29 s'exprimerait encore plus. L'amplificateur ne serait pas utilisable car il amplifie trop fortement des compostantes spectrales (il oscille quasiment), alors qu'il amortit complètement d'autres composantes spectrales. Par contre, dans l'invention, le gain est le même quelle que soit la valeur de la composante spectrale.

## Revendications

1. Amplificateur à grand gain pour amplifier des signaux électriques distribués dans une bande (28) haute fréquence, comportant un circuit (1) d'amplification, ce circuit d'amplification étant monté sur un support et étant recouvert d'un capot (11), et ce circuit d'amplification possédant, d'un premier coté (6) une entrée de signal et, d'un deuxième coté (7) opposé à ce premier coté, une sortie de signal, caractérisé en ce qu'il comporte des moyens (17, 18) de morceler en guides d'onde auxiliaires (13-15) l'espace situé entre le capot et le support, les caractéristiques des guides d'onde ainsi réalisés étant insuffisantes pour propager entre la sortie et l'entrée un signal dont la fréquence est située dans la bande haute fréquence de l'amplificateur.

2. Amplificateur selon la revendication 1, caractérisé en ce que les moyens de morceler comportent une barrette (17) à surface extérieure conductrice, aligné dans un sens allant de l'entrée à la sortie de l'amplificateur, et placée, entre le support et le capot, sur le bord de circuits intégrés formant le circuit d'amplification.

3. Amplificateur selon la revendication 2, caractérisé en ce que la barrette est réalisée en deux tronçons (17, 172) alignés.

4. Amplificateur selon l'une des revendications 1 à 3, caractérisé en ce que le circuit d'amplification comporte un espace (22) de transition, à fréquence de coupure basse plus élevée que la bande haute fréquence, et en ce que, à l'endroit de cet espace de transition, les caractéristiques (23, 24) des guides d'onde auxiliaires sont modifiées.

5. Amplificateur selon l'une des revendications 1 à 4, caractérisé en ce qu'il comporte un boîtier (30) muni d'un couvercle (31) et, à l'intérieur du boîtier, au moins un circuit (1) d'amplification, et en ce qu'un espace (33) entre ce couvercle et le capot du circuit d'amplification est morcelé par des guides d'onde (41-43) complémentaires dont les caractéristiques sont insuffisantes pour propager un signal dont la fréquence est située dans la bande haute fréquence de l'amplificateur.

6. Amplificateur selon la revendication 5, caractérisé en ce que l'espace entre le couvercle et le capot est morcelé par des barrettes élastiques à surface extérieure conductrice.

7. Amplificateur selon l'une des revendications 5 à 6, caractérisé en ce que le couvercle possède une cavité profonde ménagée dans un canal (34), cette cavité profonde recevant les guides d'onde complémentaires, le canal servant à relier et isoler l'entrée (6) et la sortie (20) du circuit d'amplification respectivement à une entrée (39) et une sortie (38) du boîtier.

8. Amplificateur selon l'une des revendications 1 à 7, caractérisé en ce que les dimensions des guides auxiliaires ou complémentaires sont insuffisantes pour laisser se propager le mode LSM11 ou le mode TE10.

9. Amplificateur selon l'une des revendications 1 à 8, caractérisé en ce que le capot (11) est métallique.
